# EUROPEAN PATENT APPLICATION

(11) **EP 0 527 337 A1**
(43) Date of publication of application: **17.02.1993**
(21) Application number: 92111804.8
(22) Date of filing: 10.07.1992
(51) Int. Cl.: G01R 31/308

(54) **Semiconductor integrated circuit**

(30) Priority: 11.07.1991 JP 170802/91
(71) Applicant: NEC CORPORATION, Tokyo (JP)
(72) Inventor: Sanada, Masaru, c/o NEC Corporation, Minato-ku, Tokyo (JP)
(74) Representative: Pätzold, Herbert, Dr.-Ing.

(57) **Abstract**

A semiconductor integrated circuit includes a CMOS gate formed on a p-semiconductor substrate, and an N⁺ region formed in the substrate. The CMOS gate has an input line connected to an external power supply and an output line connected to the N ⁺ region. When laser beam is irradiated to the N⁺ region, OBIC (optical induced current) is detected at the external power supply, so that a logical analysis of the CMOS gate is carried out.

## Description

### FIELD OF THE INVENTION

This invention relates to a semiconductor integrated circuit, and more particularly to, a semiconductor integrated circuit which is provided with a logical circuit.

### BACKGROUND OF THE INVENTION

The circuit pattern of a semiconductor IC (integrated circuit), for instance, including CMOS (complementary metal-oxide semiconductor) inverters has become higher in density in these days. For this pattern structure, the area of regions such as drain, source, etc., has been smaller and smaller, and interconnections for electrically connecting respective regions and there regions have been multi-layered.

In this semiconductor IC, the logical analysis is carried out by detecting OBIC (optical induced current). The OBIC method comprises the steps of radiating a laser light on drain regions of the CMOS inverter, and supplying "high" and "low" signals to an input of the CMOS inverter.

In this OBIC method, no OBIC flows through a power supply connected to a p-MOS transistor of the CMOS inverter, when "high" signal is supplied to the input thereof. On the other hand, an OBIC flows through the power supply, when "low" signal is supplied to the input of the CMOS inverter. When these results are obtained in the logical analysis, the CMOS inverter is determined to operate correctly.

However, the conventional semiconductor IC has a disadvantage in that error detection may occur in diagnosing operation thereof, because a laser light of a diameter larger than an area of the drain regions radiates an area other than the drain regions, such as a gate electrode, an adjacent transistor, etc.

Another disadvantage is that the OBIC method can not be carried out in case where the drain regions are patterned under a metal interconnection. In such a semiconductor IC, an extended drain region is provided to extend to a portion which is not under the metal interconnection. However, this extended drain-structure provides a drawback that the characteristics of the semiconductor IC fluctuates to deviate out of rated characteristics. In accordance with the characteristic fluctuation, the design of semiconductor ICs needs more time.

Instead of providing the extended drain region, the OBIC method is carried out by radiating a laser light on a transistor which is adjacent to a transistor in which a drain region is patterned under a metal interconnection. In this case, operation of a transistor to be checked is estimated by the result of the adjacent transistor. This also needs more time, and, sometime, provides error diagnosis. This explanation of the conventional semiconductor IC will be made in more detail in the description just prior to that of the preferred embodiments.

### SUMMARY OF THE INVENTION

Accordingly, it is an object of the invention to provide a semiconductor integrated circuit in which a logical analysis thereof can be carried out precisely, even if the circuit has high integrated and multi-layered structure.

According to the invention, a semiconductor integrated circuit, includes:
at least one CMOS gate which is formed on a semiconductor substrate, the CMOS gate having a power supply line connected to an external power supply and an output line connected to a following signal stage; and
an N⁺ region formed in the semiconductor substrate to be connected to the output line;
wherein the N ⁺ region is irradiated with laser beam so that a logical analysis of the CMOS gate is carried out by detecting an occurrence of OBIC (optical induced current) at the external power supply.

### BRIEF DESCRIPTION OF THE DRAWINGS

The other objects and features of this invention will become understood from the following description with reference to the accompanying drawings; wherein:
Fig. 1 is a block diagram showing a whole structure of a conventional OBIC detecting system;
Fig. 2 is a block diagram showing a part of the conventional OBIC detecting system;
Fig. 3 is a cross sectional view showing a conventional semiconductor integrated circuit;
Fig. 4 is a circuit diagram showing the conventional semiconductor integrated circuit;
Figs. 5 and 6 are cross sectional views showing operation of the conventional semiconductor integrated circuit;
Fig. 7 is a diagram (plan view) showing a semiconductor integrated circuit of a first preferred embodiment according to the invention;
Fig. 8 is a cross sectional view showing the first preferred embodiment;
Fig. 9 is a circuit diagram showing the first preferred embodient;
Figs. 10 and 11 are cross sectional views showing operation of the first preferred embodiment;
Fig. 12 is a diagram (plan view) showing a semiconductor integrated circuit of a second preferred embodiment according to the invention; and
Fig. 13 is a cross sectional view showing the second preferred embodiment.

### DESCRIPTION OF THE PREFERRED EMBODIMENTS

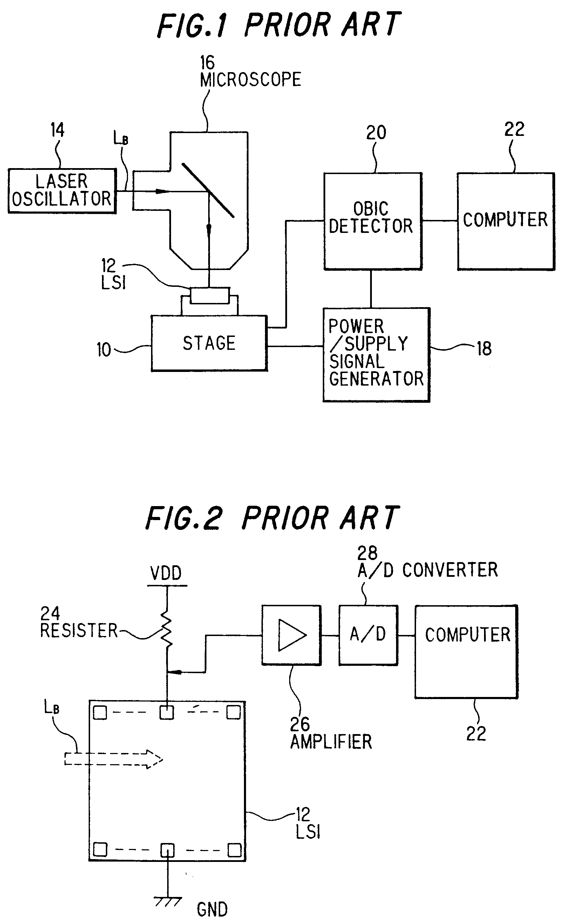

For better understanding the background of the present invention, the basic principle of the conventional technology is first described hereinafter with reference to Figs. 1 to 6.

Fig. 1 shows a whole structure of a conventional OBIC (optical induced current) detecting system, and Fig. 2 shows a part of the conventional OBIC detecting system, respectively. The conventional OBIC detecting system includes a stage 10 on which an LSI 12 is set, a laser oscillator 14 for generating He-Ne laser beam "L _{B} ", a microscope 16 for converging and guiding the laser beam "L _{B} " to the LSI 12, a power supply / signal generator 18 for supplying a power voltage V _{DD} and a predetermined signal to the LSI 12 through the stage 10, an OBIC detector 20 for detecting OBIC, and a computer 22 connected to the OBIC detector 20 for analyzing a logical operation of the LSI 12, as shown in Fig. 1.

The OBIC detector 20 includes an amplifier 26 connected a nodal point between the LSI 12 and a resister 24 connected to a power supply V _{DD} for amplifying a detected voltage, and an A/D (analog-digital) converter 28 connected between the amplifier 26 and the computer 22 for converting an analog signal to a digital signal, as shown in Fig. 2.

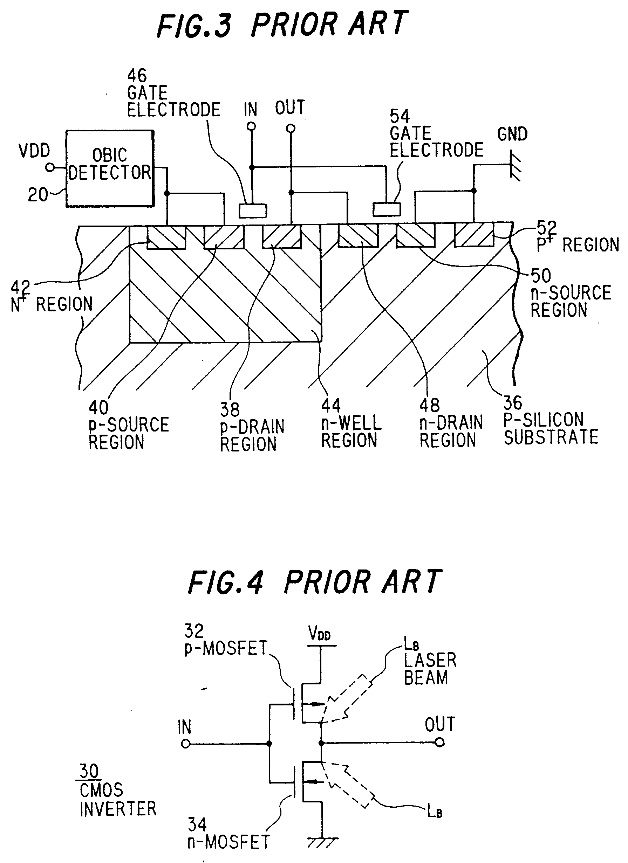

Figs. 3 and 4 show a CMOS (complementary metal-oxide semiconductor) inverter 30 formed in the LSI 12 to be checked in logical operation. The CMOS inverter 30 is composed of a p-MOSFET 32 and an n-MOSFET 34 each formed on a p-silicon substrate 36. The p-MOSFET 32 includes a p-drain region 38, a p-source region 40, an N ⁺ diffused region 42 for voltage clamp, each formed in an n-well region 44 in the p-silicon substrate 36, and a gate electrode 46 formed on an insulation layer (not shown) across the p-drain region 38 and the p-source region 40. The p-MOSFET 32 is connected at the gate electrode 46 to a common input terminal IN, at the p-source region 40 to a power supply V _{D D} and at the p-drain region 38 to a common output terminal OUT.

On the other hand, the n-MOSFET 34 includes an n-drain region 48, an n-source region 50, a P⁺ region 52 for voltage clamp each formed on the p-silicon substrate 36, and a gate electrode 54 formed on an insulation layer (not shown) across the n-drain region 48 and the n-source region 50. The n-MOSFET 34 is connected at the gate electrode to the common input terminal IN, at the n-source region 50 to ground and at the n-drain region 48 to the common output terminal OUT.

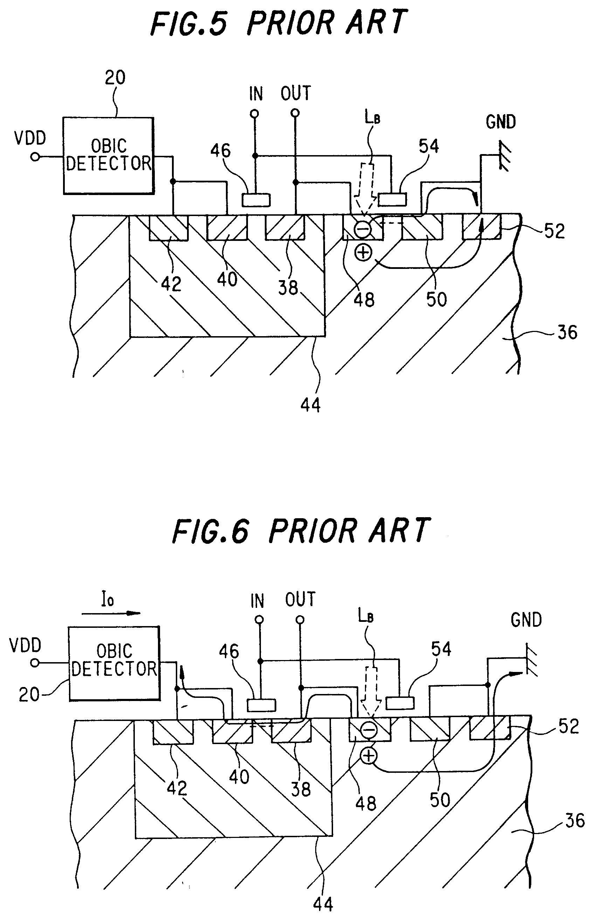

Next, operation of logical analysis of the CMOS inverter 30 will be explained in conjunction with Figs. 5 and 6. When, an input signal of "1" level is supplied to the input terminal IN, the p-MOSFET is turned off and the n-MOSFET is turned on. In this situation, when laser beam L _{B} is irradiated to the n-drain region 48 of the n-MOSFET 34, electron and hole are generated in pairs around the n-drain region 48. The holes are supplied to ground via the p-silicon substrate 36 and the P ⁺ region 52, and the electrons are supplied to the n-source region 50 via a channel region of the n-MOSFET 34, as shown in Fig. 5. At this time, the electrons and the holes are canceled each other, because the n-source region 50 and the P ⁺ region 52 is connected, so that no OBIC is detected by the OBIC detector 20.

On the other hand, when an input signal of "0" level is supplied to the input terminal IN, the p-MOSFET is turned on and the n-MOSFET is turned off. In this situation, when laser beam L _{B} is irradiated to the n-drain region 48 of the n-MOSFET 34, electron and hole are generated in pairs around the n-drain region 48. The holes are supplied to ground via the p-silicon substrate 36 and the P ⁺ region 52, and the electrons are supplied to the power supply V _{DD} through the p-MOSFET 32, as shown in Fig. 6. As a result, OBIC I _{O} is detected by the OBIC detector 20.

According to the conventional LSI 12, a logical analysis thereof can be carried out with no-contact by using the laser beam L _{B} . However, there are disadvantages in that it is difficult to irradiate the laser beam L _{B} to the drain of the CMOS inverter, because a circuit density of the LSI 12 becomes high. Therefore, there is the possibility of the laser beam L _{B} being irradiated to other portions, so that a miss analysis occurs, as described before.

Further, if the LSI 12 has a multi-layered structure, most of active regions are buried with a conductive layer (not shown), so that no laser beam reaches to a drain region of the transistor to be analyzed. In this case, if the laser beam L _{B} is irradiated to a drain region of a not buried transistor, the above problem can be solved, however, it takes long time for the logical analysis of buried transistors, and a result of the logical analysis has low confidence. Otherwise, if the drain region of the transistor is expanded to be exposed, the above problem is solved, however, a characteristics of the LSI 12 is changed by the expansion of the drain region, as also described before.

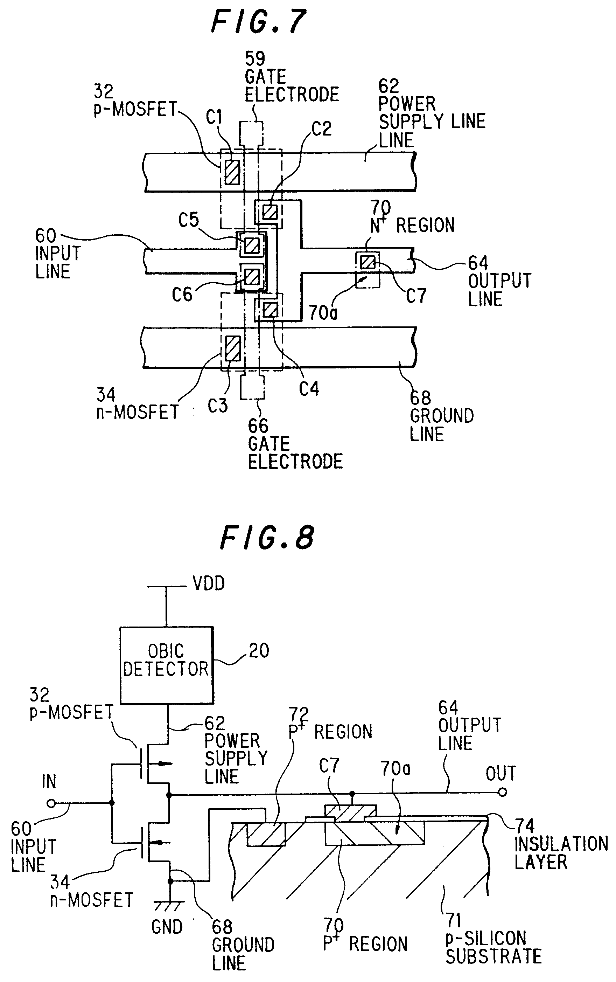

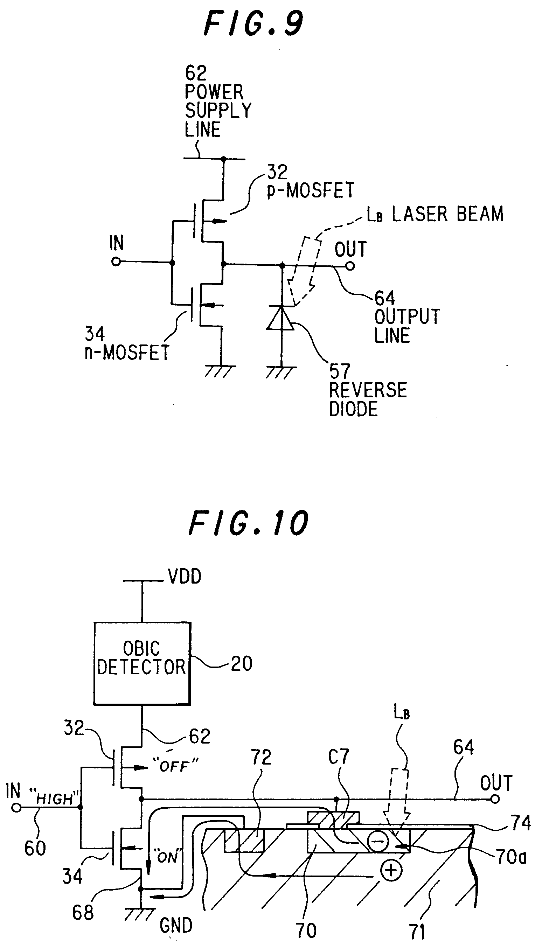

Next, an LSI of a first preferred embodiment according to the invention will be explained in conjunction with Figs. 7 to 9. The LSI includes a p-MOSFET 32, an n-MOSFET 34 and a reverse diode 57 (Fig. 9). The p-MOSFET 32 is connected at a gate electrode 59 to an input line 60 through a contact hole C5, at a source to a power supply line 62 through a contact hole C1 and at a drain to an output line 64 through a contact hole C2. The n-MOSFET 34 is connected at a gate electrode 66 to the input line 60 through a contact hole C6, at a source to ground line 68 through a contact hole C3 and at a drain to the output line 64 through a contact hole C4.

The reverse diode 57 includes an N ⁺ diffused region 70 and a P ⁺ region 72 each formed in a p-silicon substrate 71, and an insulation layer 74 formed on the p-silicon substrate 71. The N ⁺ diffused region 70 is connected to the output line 64 through a contact hole C7, and the P ⁺ region 72 is connected to the ground line 68. The N ⁺ diffused region 70 is formed to have an extended region 70a extending not to be overlapped with the output line 64, as shown in Fig. 7. Each of the power supply line 62, the ground line 68, the input line 60 and the output line 64 is made of aluminium.

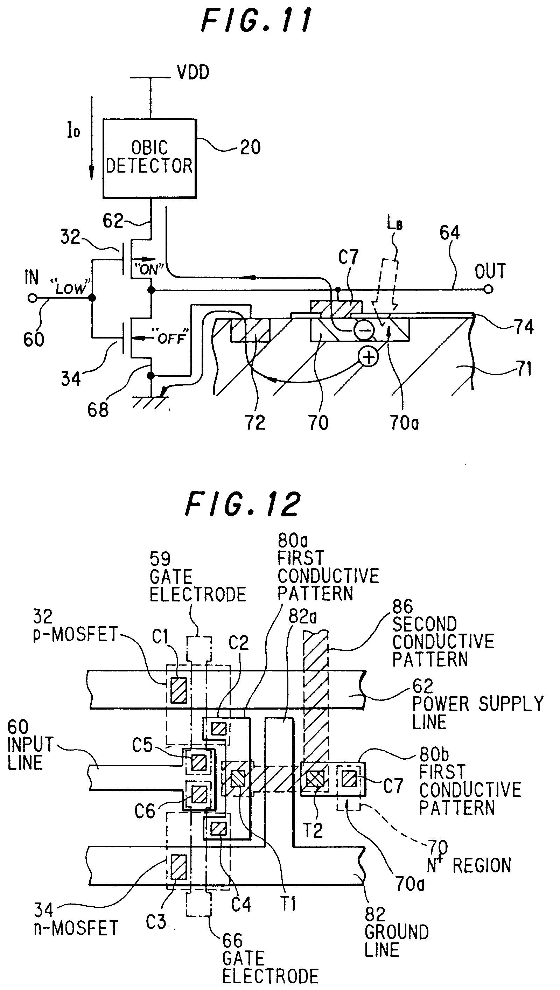

Next, operation of logical analysis of the first preferred embodiment will be explained in conjunction with Figs. 10 and 11. When, an input signal of "1" level is supplied to the input terminal IN, as shown in Fig. 10, the p-MOSFET is turned off and the n-MOSFET is turned on. In this situation, when laser beam L _{B} is irradiated to the extended portion 70a of the N ⁺ diffused region 70, electron and hole are generated in pairs around the N-P junction of the reverse diode 57. At this time, the holes are supplied to ground via the p-silicon substrate 71 and the P ⁺ region 72, and the electrons are supplied to ground via the contact hole C7, the output line 64 and the n-MOSFET 34 of on state, as shown in Fig. 10. Then, the electrons and the holes are canceled each other, so that no OBIC is detected by the OBIC detector 20.

On the other hand, when an input signal of "0" level is supplied to the input terminal IN, as shown in Fig. 11, the p-MOSFET is turned on and the n-MOSFET is turned off. In this situation, when laser beam L _{B} is irradiated to the extended portion 70a of the N ⁺ diffused region 70, electron and hole are generated in pairs around the N-P junction of the reverse diode 57. At this time, the holes are supplied to ground via the p-silicon substrate 71 and the P ⁺ region 72, and the electrons are supplied to the power supply V _{DD} via the contact hole C7 and the p-MOSFET 32 of on state, as shown in Fig. 11. As a result, OBIC I_{O} flows through the OBIC detector 20, so that the OBIC I_{O} is detected thereby.

As describe above, according to the first preferred embodiment, even if a circuit density of the LSI becomes high, logical analysis thereof can be carried out certainly. Further, because the P-N junction diode 57 does not hinder high integration. Especially, the invention is useful for a gate array logic circuit, because the advantage of the invention can be obtained by only forming an N ⁺ diffused region in a channel region thereof. In the invention, N ⁺ diffused regions do not have to be provided at each CMOS gate, that is, it is sufficient that the N ⁺ diffused regions are provided at some selected CMOS gates.

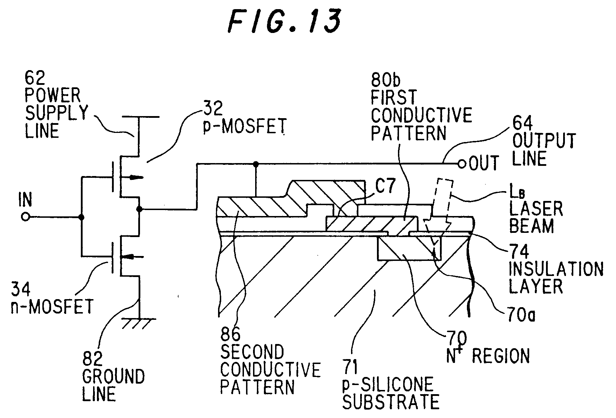

Next, an LSI of a second preferred embodiment according to the invention will be explained in conjunction with Figs. 12 and 13. The LSI includes a CMOS inverter which is composed of a p-MOSFET 32 and an n-MOSFET 34. The p-MOSFET 32 is connected at a gate electrode 59 to an input line 60 through a contact hole C5, at a source to a power supply line 62 through a contact hole C1 and at a drain to a first conductive pattern 80a through a contact hole C2. The n-MOSFET 34 is connected at a gate electrode 66 to the input line 60 through a contact hole C6, at a source to ground line 82 through a contact hole C3 and at a drain to the first conductive pattern 80a through a contact hole C4. The first conductive pattern indicated by 80a and 80b is connected to a second conductive pattern 86 by through holes T1 and T2, wherein the portions 80a and 80b of the first conductive pattern are shown in Fig. 12, and only the portion 80b thereof is shown in Fig. 13. The first conductive pattern 80b is connected to an N ⁺ diffused region 70 formed on a p-silicon substrate 74 through a contact hole C7. The N ⁺ diffused region 70 is formed to have an extended region 70a extending not to be overlapped with the first conductive pattern portion 80b.

In the second preferred embodiment, a logical analysis of the LSI is carried out in the same manner as the first preferred embodiment. That is, OBIC I_{O} is not detected when an input signal of "1" level is supplied to the input terminal IN, and OBIC I_{O} is detected when an input signal of "0" level is supplied to the input terminal IN.

According to the second preferred embodiment, even if the LSI has a multi-layered structure, a logical analysis thereof can be carried out with high precision without an influence to characteristics thereof. As apparent from Fig. 12, the ground line has an extended portion 82a, by which other regions are overlapped dependent on a circuit structure. Even in this case, a region to which a laser bean L_{B} is irradiated can be provided without hindering the high integration of an LSI.

Although the invention has been described with respect to specific embodiment for complete and clear disclosure, the appended claims are not to be thus limited but are to be construed as embodying all modification and alternative constructions that may occur to one skilled in the art which fairly fall within the basic teaching herein set forth.

## Claims

1. A semiconductor integrated circuit, comprising:
at least one CMOS gate which is formed on a semiconductor substrate, said CMOS gate having a power supply line connected to an external power supply and an output line connected to a following signal stage; and
an N⁺ region formed in said semiconductor substrate to be connected to said output line;
wherein said N⁺ region is irradiated with laser beam so that a logical analysis of said CMOS gate is carried out by detecting an occurrence of OBIC (optical induced current) at said external power supply.

2. A semiconductor integrated circuit, according to claim 1, wherein:
said N⁺ region is provided with an expanded portion not overlapped with said output line so that said laser beam is irradiated thereto.

3. A semiconductor integrated circuit, according to claim 1 or 2, wherein: said N⁺ region and said output line are
layered through an insulation layer to be connected by a conductive hole provided in said insulation layer.

4. A semiconductor integrated circuit, comprising:
at least one CMOS gate which is formed on a p-semiconductor substrate, said CMOS gate having a power supply line connected to an external power supply and an output line connected to a following signal stage; and
a diode comprising an N ⁺ region as a cathode formed in said p-semiconductor substrate, said diode being connected in reverse direction between said output line and ground;
wherein said N⁺ region is irradiated with laser beam so that a logical analysis of said CMOS gate is carried out by detecting an occurrence of OBIC (optical induced current) at said external power supply.

5. A semiconductor integrated circuit, according to claim 4, wherein:
said N⁺ region is provided with an expanded portion not overlapped with said output line so that said laser beam is irradiated thereto.

6. A semiconductor integrated circuit, according to claim 4 or 5, wherein:
said N⁺ region and said output line are layered through an insulation layer to be connected by a conductive hole provided in said insulation layer.

7. A semiconductor integrated circuit, comprising:
at least one gate circuit provided on a semiconductor substrate, said gate circuit being provided with input and output lines and applied with a logical operation voltage between power supply and ground lines; and
an optically operating device positioned between said output line and a fixed potential point, said device carrying out no operation under an ordinary operation state of said gate circuit, and carrying out operation by receiving a light to induce current flowing through said power supply line.

8. A semiconductor integrated circuit, according to claim 7, wherein:
said gate circuit is an inverter comprising P-and-N CMOS transistors provided in a P-semiconductor substrate; and
said optically operating device is a revers diode provided in said P-semiconductor substrate by forming an N ⁺ -region in said P-semiconductor substrate, said N ⁺ -region having an extended portion which is not optically shielded by said output line, a light for a logical analysis being incident to said extended portion under a state which "high" and "low" logical signal are supplied on said input line, respectively.
